# FASCICULE DE BREVET EUROPEEN

(11) **EP 2 141 116 B1**
(45) Date de publication et mention de la délivrance du brevet: **16.07.2014**
(21) Numéro de dépôt: 09164017.7
(22) Date de dépôt: 29.06.2009
(51) Int. Cl.: B81B 7/00

(54) **Structure à base d'un matériau getter suspendu**
Struktur eines aufgehängten Getter-Materials
Structure based on a suspended getter material

(30) Priorité: 01.07.2008 FR 0854451
(43) Date de publication de la demande: 06.01.2010
(73) Titulaire: Commissariat à l'Énergie Atomique et aux Énergies Alternatives, 75015 Paris (FR)
(72) Inventeur: Caplet, Stéphane, 38360, Sassenage (FR); Baillin, Xavier, 38920, Crolles (FR)
(74) Mandataire: Ilgart, Jean-Christophe

(56) Documents cités:
- US-A1- 2002 056 898
- US-A1- 2004 061 207

## Description

### DOMAINE TECHNIQUE

L'invention concerne une structure à base d'un matériau getter. Une telle structure peut notamment être utilisée dans le domaine des microsystèmes électromécaniques (MEMS) ou nanosystèmes électromécaniques (NEMS), par exemple des accéléromètres, des gyromètres, ou tout autre dispositif destiné à être disposé dans un environnement sous vide poussé ou sous pression contrôlée.

### ÉTAT DE LA TECHNIQUE ANTÉRIEURE

Un matériau getter est un matériau comportant, de façon intrinsèque et/ou de par sa morphologie microscopique, des propriétés absorbantes et/ou adsorbantes vis-à-vis de molécules gazeuses, pouvant ainsi former une pompe de gaz chimique lorsque celui-ci est disposé dans un environnement clos. Ce type de matériau peut également être utilisé dans de nombreuses applications microélectroniques telles que les tubes à vide, les systèmes à effet de champ ou encore les MEMS ou NEMS, pour réaliser un environnement sous vide poussé ou sous pression contrôlée. Dans le cas des MEMS ou NEMS encapsulés, un environnement sous vide poussé formé autour du dispositif permet par exemple d'obtenir un meilleur fonctionnement des systèmes mécaniques résonnants mais aussi des systèmes optiques sensibles à l'absorption du rayonnement lumineux par des gaz environnants.

Des matériaux getter non évaporables sont par exemple des métaux tels que du titane, du zirconium, de l'hafnium, ou encore des alliages métalliques binaires de ces trois métaux. Un tel matériau getter non évaporable est généralement déposé directement sur une paroi de l'enceinte dans laquelle on cherche à réaliser une pompe chimique sous la forme d'une couche mince. Ce matériau est ensuite activé thermiquement en le chauffant à travers la paroi de l'enceinte sur laquelle il est déposé. Le document US 6 923 625 B2 décrit la réalisation d'une telle couche mince de matériau getter.

La capacité de pompage d'une telle couche mince de matériau getter est déterminée par la surface du matériau en contact avec le gaz à absorber. Plus cette surface est grande, plus la capacité d'absorption du matériau getter est importante. Dans le document US 6 923 625 B2, il est décrit notamment que la couche mince de matériau getter peut être déposée sur une surface présentant des saillies. Ainsi, la surface du matériau getter déposé sur les parois latérales des saillies permet d'augmenter la surface totale absorbante du matériau getter dans la cavité.

L'inconvénient majeur d'une telle couche mince de matériau getter est la puissance, c'est-à-dire la quantité d'énergie et le temps de chauffe, nécessaire pour réaliser son activation thermique.

Le document EP 1 518 599 A2 décrit la réalisation de deux couches superposées de matériau getter dont l'une, déposée contre un substrat, est à base d'un matériau getter à faible température d'activation. Un tel empilement de matériaux getter permet d'obtenir de meilleures capacités d'absorption des gaz et peut être activé thermiquement avec une température d'activation plus basse que celle nécessaire pour une simple couche mince de matériau getter.

Le document US 2002/056898 A1 décrit une structure getter comportant un substrat et une couche à base d'un matériau getter reliée mécaniquement au substrat par l'intermédiaire d'un support, une première face de la couche de matériau getter étant en contact avec le support, et une seconde face de la couche de matériau getter, opposée à ladite première face, est découverte.

### EXPOSÉ DE L'INVENTION

Un but de la présente invention est de proposer une structure à base d'un matériau getter demandant une puissance d'activation thermique inférieure à celle nécessaire pour activer thermiquement les structures connues de matériau getter, offrant une grande surface d'absorption gazeuse et présentant une faible inertie thermique.

Pour cela, la présente invention propose une structure getter telle que définie dans la revendication 1.

L'invention concerne également une structure getter comportant un substrat et au moins une couche à base d'au moins un matériau getter reliée mécaniquement au substrat par l'intermédiaire d'au moins un support, la surface du support en contact avec le substrat étant inférieure à la surface d'une première face de la couche de matériau getter, ladite première face étant en contact avec le support, et une seconde face de la couche de matériau getter, opposée à ladite première face, étant au moins en partie découverte.

L'expression « au moins en partie découverte » signifie que la seconde face de la couche n'est pas complètement recouverte par un élément, cette face étant donc apte à réaliser une absorption gazeuse.

Ainsi, grâce au support, la couche de matériau getter n'a pas de contact thermique direct avec le substrat. De plus, étant donné que la surface du support en contact avec le substrat est inférieure à celle de la couche de matériau getter en contact avec le support, la puissance, c'est-à-dire la quantité d'énergie et le temps de chauffe, pour réaliser l'activation thermique du matériau getter est donc inférieure à la puissance utilisée pour l'activation thermique d'une couche de matériau getter ou d'un empilement de couches de matériau getter déposé directement sur un substrat.

De plus, le fait que la seconde face soit au moins en partie découverte assure à la structure getter une faible inertie thermique.

Il est possible que l'inertie thermique de la couche de matériau getter représente au moins 10% de l'inertie thermique totale de la structure getter.

La surface des parties du support en contact avec le substrat au-dessus desquelles se trouve la couche de matériau getter peut être inférieure à la surface d'une face principale de la couche de matériau getter en contact avec le support.

Une partie, par exemple au plus 10 %, ou 20 %, ou 30 %, ou 40 %, ou 50 %, de la surface de la face principale de la couche de matériau getter peut être en contact avec le support formé par exemple par des espaceurs disposés entre la couche de matériau getter et le substrat.

La surface de la première face de la couche de matériau getter en contact avec le support peut être inférieure à la surface de la première face de la couche de matériau getter qui n'est pas en contact avec le support.

La couche de matériau getter peut avoir pour unique pont thermique de conduction le support. Ainsi, la couche de matériau getter est libre thermiquement car le support est le seul élément formant un pont thermique de conduction avec la couche de matériau getter, la couche de matériau getter n'étant en contact avec aucun autre élément formant un pont thermique de conduction.

De plus, la surface du matériau getter se trouvant du côté du support, mais qui n'est pas en contact avec le support, permet d'augmenter la surface totale d'absorption de la couche du matériau getter. En effet, une telle structure permet d'utiliser non seulement la face avant de la couche de matériau getter, mais également une partie de la face arrière de la couche de matériau getter pour réaliser une absorption gazeuse. Ainsi, pour une même quantité de matériau getter, une telle structure getter suspendue permet d'obtenir une plus grande capacité d'absorption que celle obtenue par une couche mince ou un empilement de couches de matériau getter déposé directement sur le substrat.

De plus, étant donné qu'aucun élément ne recouvre la seconde face de la couche de matériau getter, une telle structure getter présente une faible inertie thermique, contrairement aux dispositifs de l'art antérieur dans lesquels une couche de matériau getter est recouverte par un élément. Compte tenu de cette faible inertie thermique et de l'absence de contact thermique direct entre le substrat et la couche de matériau getter, il est possible d'activer le matériau getter de manière indépendante vis-à-vis des autres éléments présents autour du matériau getter.

La structure peut comporter une ou plusieurs couches de matériau getter, cette ou ces couches pouvant être à base d'un ou plusieurs matériaux getter différents.

Le substrat peut être avantageusement à base d'au moins un matériau thermiquement isolant tel que du verre, améliorant ainsi l'isolation thermique entre le substrat et le matériau getter. Dans une variante, le substrat peut également être à base d'autres matériaux tels que du silicium, du covar, etc.

Lorsqu'au moins une partie du support est à base d'un matériau conducteur, tel que du silicium dopé, un isolant électrique peut alors être disposé entre le support et d'éventuels autres matériaux conducteurs destinés à être en contact avec le support.

Le support peut être au moins en partie à base d'un matériau getter.

Le support peut comporter au moins un espaceur disposé entre la couche de matériau getter et le substrat.

Le support peut comporter au moins une couche structurée à base d'au moins un matériau résistif et au moins un espaceur disposé entre la couche résistive et le substrat, la couche de matériau getter pouvant être disposée contre la couche résistive. Ainsi, en plus de réaliser une isolation thermique entre le substrat et le matériau getter, la couche résistive permet de réaliser une activation thermique par effet Joule du matériau getter en faisant passer un courant à travers ce matériau résistif. De manière avantageuse, la couche résistive peut être à base de tungstène. Toutefois, cette couche résistive peut également être à base d'or, de molybdène, ou tout autre matériau adapté à une activation thermique par effet Joule du matériau getter.

Il est également possible d'intégrer une couche barrière, par exemple à base de Pt ou de WN, entre la couche résistive et la couche de matériau getter, permettant ainsi d'éviter une éventuelle diffusion du matériau getter.

Dans le cas de l'utilisation d'une couche résistive, l'espaceur peut être à base du matériau résistif. De plus, le motif de structuration de la couche résistive peut être un serpentin. On entend par serpentin, ici et dans tout le reste du document, une ligne continue coudée plusieurs fois en forme d'épingles successives. Ce motif peut également former une ligne continue enroulée en spirale. Une couche du matériau résistif structurée selon ce motif permet notamment de réaliser une bonne résistance chauffante. Une grande partie de la surface de la couche de matériau getter qui est en contact avec le matériau résistif est alors chauffée.

La couche de matériau getter peut être structurée selon un motif sensiblement similaire à celui de la couche résistive.

Dans une variante, la couche de matériau résistif peut être réalisée au-dessus de la couche de matériau getter, la couche de matériau getter étant disposée entre le substrat, ou le support, et la couche résistive.

Dans une autre variante, le rôle de couche résistive peut également être rempli par la couche de matériau getter elle-même. Dans ce cas, l'activation thermique par effet Joule peut se faire en faisant passer un courant directement dans la ou les couches de matériau getter.

L'espaceur peut comporter, dans un plan parallèle au plan de la face principale de la couche de matériau getter, une section dont la surface peut être comprise entre environ 4 µm² et 25 µm². Cette surface est de préférence minimisée afin de limiter le pont thermique entre la couche de matériau getter et le substrat, et donc les pertes thermiques. Toutefois, la valeur de cette surface peut dépendre notamment de la filière technologique de la réalisation de la structure getter, qui peut imposer une surface minimum. De plus, la valeur de cette surface dépend également de la tenue mécanique nécessaire pour réaliser cette structure et former de bons ancrages du matériau getter : par exemple, si des déformations des parties suspendues apparaissent par effet de gradients de contraintes ou par effet de flambage, une surface suffisante sera choisie pour que ces déformations ne créées pas de nouveaux ponts thermiques ou ne viennent pas occuper un espace non désiré. Une section de surface comprise entre environ 4 µm² et 25 µm² peut correspondre à la filière technologique MEMS avec une optimisation de la surface suspendue du matériau getter par rapport à la section des espaceurs.

De plus, lorsque le support comporte une pluralité d'espaceurs, deux espaceurs voisins peuvent être séparés l'un de l'autre d'une distance comprise entre environ 20 µm et 50 µm, offrant ainsi un bon compromis entre isolation thermique et tenue mécanique. Cette distance est particulièrement intéressante lorsque la structure comporte une couche résistive d'épaisseur comprise entre environ 0,5 µm et 2 µm.

Le support comporte une paroi périphérique d'une cavité disposée entre la couche de matériau getter et le substrat.

La structure comporte en outre au moins une ouverture réalisée à travers la couche de matériau getter, formant un accès à la cavité. Les parois internes de la cavité formées par le matériau getter peuvent donc former également des surfaces absorbantes d'espèces gazeuses.

La structure peut comporter en outre une couche d'isolation thermique et/ou une couche d'adhérence disposée entre le support et la couche de matériau getter et/ou entre le support et le substrat.

La couche d'isolation thermique peut être à base d'un oxyde de semi-conducteur et/ou la couche d'adhérence peut être à base de titane et/ou de chrome et/ou de zirconium, ou tout autre matériau adapté pour former ces couches.

Le substrat peut être à base d'au moins un matériau transparent à au moins une longueur d'onde pouvant être absorbée par le matériau getter. Ainsi, on peut réaliser une activation thermique du matériau getter par l'intermédiaire de faisceaux lumineux tels que des faisceaux laser ou un rayonnement infrarouge traversant le substrat.

La présente invention concerne également un système microélectronique comportant au moins une cavité délimitée par des parois et dans laquelle est disposé au moins un dispositif microélectronique, au moins une paroi de la cavité étant formée par une structure getter telle que décrite précédemment, la couche de matériau getter de la structure getter étant disposée dans la cavité. Le dispositif microélectronique peut être disposé en regard de la seconde face de la couche de matériau getter.

Le dispositif microélectronique peut être disposé au niveau d'une paroi de la cavité autre que celle formée par la structure getter.

Le dispositif microélectronique peut comporter au moins un MEMS et/ou un NEMS.

L'invention a également pour objet un procédé de réalisation d'une structure getter comportant au moins la réalisation d'un support reliant mécaniquement une couche à base d'au moins un matériau getter à un substrat, la surface du support en contact avec le substrat étant inférieure à la surface d'une face, pouvant être appelée face principale, de la couche de matériau getter en contact avec le support.

L'invention a également pour objet un procédé de réalisation d'une structure getter, comportant au moins les étapes de :
- dépôt d'une couche sacrificielle sur un substrat,
- dépôt d'un matériau getter, formant au moins une couche à base du matériau getter telle que la couche sacrificielle soit disposée entre la couche de matériau getter et le substrat,
- suppression d'au moins une partie de la couche sacrificielle, formant un support reliant mécaniquement la couche de matériau getter au substrat, la surface du support en contact avec le substrat étant inférieure à la surface d'une face, appelée par exemple face principale, de la couche de matériau getter, ladite face étant en contact avec le support.

Une seconde face de la couche de matériau getter, opposée à la face de la couche de matériau getter en contact avec le support, peut être au moins en partie découverte.

Le dépôt du matériau getter peut également être réalisé autour de la couche sacrificielle, le matériau getter déposé autour de la couche sacrificielle pouvant former au moins une partie du support.

Le procédé peut comporter en outre, entre l'étape de dépôt de la couche sacrificielle et l'étape de dépôt du matériau getter, une étape de réalisation d'au moins une ouverture à travers la couche sacrificielle, le dépôt du matériau getter pouvant être également réalisé dans l'ouverture, le matériau getter déposé dans l'ouverture pouvant former au moins une partie du support.

Le procédé peut comporter en outre, entre l'étape de dépôt du matériau getter et l'étape de suppression de la partie de la couche sacrificielle, une étape de réalisation d'au moins une ouverture à travers le matériau getter, pouvant former un accès à la couche sacrificielle, la suppression de la partie de la couche sacrificielle pouvant être réalisée au moins par l'intermédiaire de cette ouverture.

La réalisation de l'ouverture à travers la couche sacrificielle et/ou la réalisation de l'ouverture à travers le matériau getter peuvent être obtenues par au moins une étape de lithographie et une étape de gravure.

La ou les parties restantes de la couche sacrificielle peuvent former, après l'étape de suppression d'une partie de la couche sacrificielle, au moins une partie du support.

Le procédé peut comporter en outre, entre l'étape de dépôt de la couche sacrificielle et l'étape dépôt du matériau getter, une étape de structuration de la couche sacrificielle.

Le procédé peut comporter en outre, entre l'étape de dépôt du matériau getter et l'étape de suppression d'une partie de la couche sacrificielle, une étape de structuration de la couche de matériau getter.

Le procédé peut comporter en outre au moins une étape de dépôt d'une couche à base d'au moins un matériau résistif sur la couche sacrificielle ou sur la couche de matériau getter, mise en oeuvre entre l'étape de dépôt de la couche sacrificielle et l'étape de dépôt du matériau getter ou entre l'étape de dépôt du matériau getter et l'étape de suppression d'une partie de la couche sacrificielle, la couche de matériau getter pouvant être disposée sur ou sous la couche résistive.

Le procédé peut comporter en outre, après l'étape de dépôt de la couche résistive, une étape de structuration de la couche résistive et/ou une étape de réalisation d'ouvertures à travers la couche résistive.

Le procédé peut comporter en outre une étape de dépôt d'une couche barrière, par exemple à base de Pt ou de WN, disposée entre la couche résistive et la couche de matériau getter.

Le procédé peut comporter en outre une étape de dépôt d'une couche d'isolation thermique et/ou d'une couche d'adhérence sur le support, mise en oeuvre entre l'étape de dépôt de la couche sacrificielle et l'étape de dépôt du matériau getter, et/ou sur le substrat, mise en oeuvre avant l'étape de dépôt de la couche sacrificielle.

Le dépôt du matériau getter peut être réalisé par évaporation et/ou pulvérisation.

La suppression de la partie de la couche sacrificielle peut être réalisée par une étape de gravure plasma, par exemple dans le cas d'une couche sacrificielle à base de polymère, ou une gravure humide, par exemple dans le cas d'une couche sacrificielle à base d'un matériau métallique.

Le procédé peut comporter en outre, après l'étape de dépôt du matériau getter, une étape de dépôt d'une couche protectrice sur le matériau getter, et une étape de suppression de la couche protectrice mise en oeuvre après l'étape de suppression d'une partie de la couche sacrificielle.

L'invention concerne aussi un procédé de réalisation d'un système microélectronique, comportant au moins les étapes de :
- mise en oeuvre d'un procédé de réalisation d'une structure getter tel que décrit précédemment ;
- fermeture d'une cavité délimitée par des parois, par exemple formée sur un substrat, et dans laquelle est disposé au moins un dispositif microélectronique, la structure getter formant une paroi de la cavité, la couche de matériau getter de la structure getter étant disposée dans la cavité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 4 représentent les étapes d'un procédé de réalisation d'une structure getter, objet de la présente invention, selon un premier mode de réalisation, ainsi que les étapes d'un procédé de réalisation d'un système microélectronique, également objet de la présente invention, selon un mode de réalisation particulier,
- les figures 5 à 8 représentent les étapes d'un procédé de réalisation d'une structure getter, objet de la présente invention, selon un second mode de réalisation,
- la figure 9 représente une structure getter, objet de la présente invention, selon une variante du premier mode de réalisation,
- les figures 10 à 13 représentent les étapes d'un procédé de réalisation d'une structure getter, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

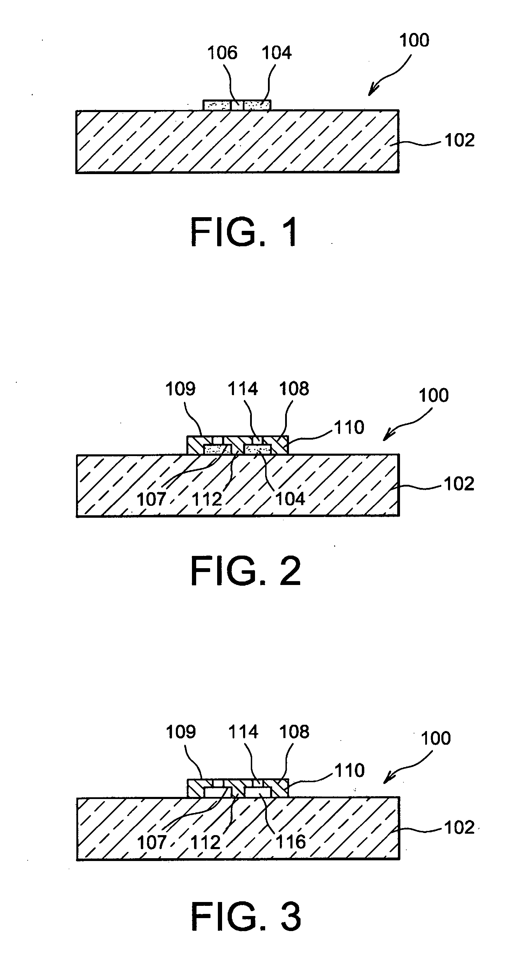

On se réfère tout d'abord aux figures 1 à 4 qui représentent les étapes d'un procédé de réalisation d'une structure getter 100 selon un premier mode de réalisation, ainsi qu'un procédé de réalisation d'un système microélectronique 1000, selon un mode de réalisation particulier, comportant la structure getter 100.

La structure getter 100 est réalisée à partir d'un substrat 102, par exemple à base de verre. Le substrat 102 pourrait également être à base d'un semi-conducteur tel que du silicium, et éventuellement être recouvert d'une couche à base d'oxyde ou de tout autre matériau apte à réaliser une isolation thermique du substrat 102. Comme représenté sur la figure 1, une couche sacrificielle 104, par exemple à base d'une résine, d'un polymère tel qu'une résine photosensible, ou d'un métal tel que du cuivre ou de l'aluminium, est déposée sur le substrat 102. Tout autre matériau sacrificiel peut être utilisé pour former la couche sacrificielle 104, par exemple un oxyde. De manière générale, la couche sacrificielle 104 peut avoir une épaisseur comprise entre environ 1 µm et 10 µm. L'utilisation de résine permet notamment de réaliser une couche sacrificielle 104 de forte épaisseur. De plus, lorsque la couche sacrificielle 104 est à base de résine, il peut être avantageux de réaliser un fluage thermique de cette couche sacrificielle 104, permettant ainsi d'adoucir les passages de marches de cette couche et donc d'améliorer la tenue mécanique de la couche de matériau getter déposée ultérieurement sur cette couche sacrificielle 104. Il est également possible de réaliser un étuvage de la couche sacrificielle lorsque celle-ci est à base de résine.

La couche sacrificielle 104 est ensuite structurée, par exemple par lithographie et éventuellement gravure, pour recevoir le dépôt d'une couche à base d'au moins un matériau getter. Des ouvertures 106 sont notamment réalisées à travers cette couche sacrificielle 104. Sur la figure 1, une seule ouverture 106 est représentée.

Comme on peut le voir sur la figure 2, un matériau getter est ensuite déposé sur la couche sacrificielle 104. Il est possible de déposer préalablement une sous-couche de protection, par exemple à base de cuivre et/ou de chrome, sur la couche sacrificielle 104, la couche de matériau getter étant ensuite déposée sur cette sous-couche de protection. Dans ce premier mode de réalisation, le matériau getter est du titane, par exemple déposé par évaporation ou pulvérisation, ou toute autre technique de dépôt appropriée. Dans une variante, le matériau getter peut être à base de chrome et/ou de titane et/ou de zirconium et/ou d'un alliage de ces matériaux, et/ou de tout autre matériau présentant des propriétés d'absorption et/ou d'adsorption de molécules gazeuses.

Le matériau getter déposé forme notamment au-dessus de la couche sacrificielle 104 une couche 108 de matériau getter dont une première face 107 est en contact avec la couche sacrificielle 104. La couche 108 de matériau getter comporte également une seconde face 109 opposée à la première face 107. Les faces 107 et 109 forment deux faces principales de la couche 108 de matériau getter. De manière générale, l'épaisseur de la couche 108 de matériau getter peut être comprise entre environ 0,2 µm et 2 µm. Le matériau getter est également déposé sur le substrat 102, autour de la couche sacrificielle 104, formant une paroi périphérique 110 sur laquelle repose la couche 108. La paroi périphérique 110 est ici formée par une portion continue de matériau getter, mais elle pourrait également être formée par plusieurs portions de matériau getter séparées les unes des autres, pouvant ainsi former des piliers. Enfin, le matériau getter est également déposé dans les ouvertures 106, formant ainsi des espaceurs 112, ou piliers de soutien, entre la couche 108 de matériau getter et le substrat 102. Sur l'exemple de la figure 2, un seul espaceur 112 est représenté. La paroi périphérique 110 et les espaceurs 112 forment donc un support sur lequel repose la couche 108 de matériau getter.

La couche 108 de matériau getter est ensuite structurée par des étapes de lithographie et de gravure, formant notamment des ouvertures 114 permettant d'accéder à la couche sacrificielle 104. Si la structure comporte une sous-couche de protection disposée sous la couche de matériau getter, les ouvertures 114 sont également réalisées à travers cette sous-couche de protection.

On réalise enfin une gravure sélective de la couche sacrificielle 104 par l'intermédiaire des ouvertures 114 réalisées précédemment à travers la couche de matériau getter 108 (voir figure 3). Dans le cas d'une couche sacrificielle à base d'un matériau polymère, la gravure est préférentiellement du type plasma ozone. Cette gravure forme sous la couche 108 une cavité 116 délimitée notamment par la paroi périphérique 110, et libère ainsi la première face 107 de la couche 108 de matériau getter.

On obtient donc une couche 108 de matériau getter qui n'est pas en contact direct avec le substrat 102, mais qui est reliée mécaniquement à celui-ci par l'intermédiaire d'un support formé ici par la paroi périphérique 110 et les espaceurs 112 également à base du matériau getter. Ces espaceurs 112 peuvent avoir une section de forme quelconque, ou de forme géométrique, dont les dimensions (diamètre, côtés, ...) sont par exemple comprises entre environ 2 µm et 5 µm. Donc, dans un plan parallèle au plan de la première face 107 de la couche 108 de matériau getter en contact avec la paroi périphérique 110 et les espaceurs 112, les espaceurs 112 peuvent avoir une section dont la surface est comprise entre environ 4 µm² et 25 µm². De plus, la distance séparant deux espaceurs 112 voisins est par exemple comprise entre environ 20 µm et 50 µm, assurant ainsi une bonne tenue mécanique de la couche 108 vis-à-vis d'éventuels risques de flambage de cette couche 108 entre les espaceurs 112.

De manière générale, la couche sacrificielle 104 peut être à base de tout matériau pouvant être gravé sélectivement par rapport au matériau getter et/ou au (x) matériau (x) de la sous-couche de protection. L'épaisseur de cette couche sacrificielle 104 est avantageusement proportionnelle, dans le cas de passages de marche importants, à l'épaisseur de la couche 108 de matériau getter souhaitée afin de ne pas former une couche trop fine ou trop épaisse de matériau getter, pour avoir une bonne tenue mécanique après l'élimination de la couche sacrificielle. Par exemple, pour une couche 108 de matériau getter dont l'épaisseur est comprise entre environ 1 µm et 2 µm, la couche sacrificielle 104 peut avoir une épaisseur comprise entre environ 0,5 µm et 1 µm.

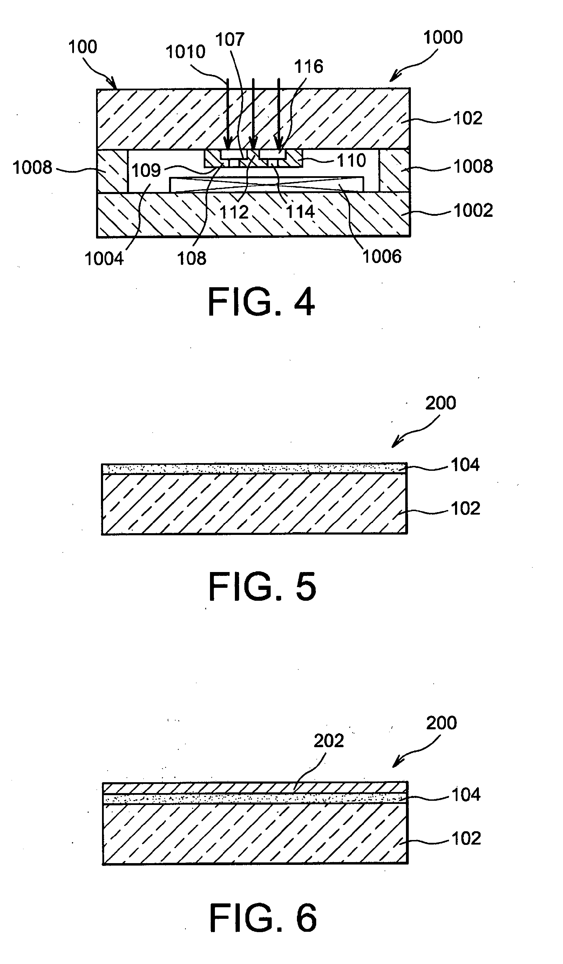

Comme représenté sur la figure 4, on intègre la structure getter 100 sur un substrat 1002 comportant une cavité 1004 dans laquelle est disposé un dispositif microélectronique 1006 tel qu'un MEMS ou un NEMS. La structure getter 100 forme une paroi supérieure de la cavité 1004. La couche 108 de matériau getter est donc suspendue dans la cavité 1004, au-dessus du dispositif 1006, par l'intermédiaire du support formé par la paroi périphérique 110 et les espaceurs 112. Sur la figure 4, le substrat 102 est relié à des parois latérales 1008 de la cavité 1004 par scellement de verre fondu (« glass frit »). Il est également possible d'envisager une configuration associée à un scellement anodique ou un collage moléculaire. Lorsque le substrat 102 est à base de verre et que les parois 1008 sont à base de silicium, on réalise de préférence un scellement anodique offrant une bonne herméticité pour la tenue au vide à l'intérieur de la cavité 1004.

On réalise ensuite l'activation thermique du matériau getter de la structure 100, c'est-à-dire ici de la couche 108 ainsi que du support formé par la paroi périphérique 110 et les espaceurs 112. Sur l'exemple de la figure 4, l'activation thermique est réalisée par l'intermédiaire d'une source laser dont les faisceaux 1010 sont représentés. Dans ce premier mode de réalisation, le substrat 102 est transparent, au moins localement au niveau du matériau getter, à la longueur d'onde des faisceaux 1010. Ainsi, l'énergie apportée par ces faisceaux est absorbée par le matériau getter de la structure 100 présent dans la cavité 1004.

L'activation thermique peut également être réalisée par un rayonnement infrarouge, par exemple de longueur d'onde λ = 1 µm. Dans ce cas, lorsque la couche 108 de matériau getter a une épaisseur supérieure à environ 0,1 µm, celle-ci absorbe environ 45 % de l'énergie lumineuse. La puissance de la lampe utilisée pour réaliser cette activation thermique est donc fonction des dimensions et de la conductivité thermique des matériaux de la couche de matériau getter, des espaceurs et de la paroi périphérique, ainsi que de l'espacement entre les espaceurs, c'est-à-dire de la densité des espaceurs supportant la couche 108 de matériau getter, et de la conductivité thermique du substrat. Par exemple, pour des espaceurs dont le pont thermique formé par chacun est égale à environ 25 µW/K (cas d'un substrat de silicium avec une couche d'isolation thermique à base d'oxyde de 1 µm), et dont la densité de répartition est égale à environ 40000 espaceurs/cm², une lampe de 700 W/cm² peut être utilisée pour chauffer le matériau getter à une température de l'ordre de 300°C. Une lampe moins puissante peut être utilisée lorsque l'on réduit la densité des espaceurs et/ou la conductivité thermique des espaceurs et/ou de la paroi périphérique, et/ou si l'on réduit fortement la conductivité thermique du substrat, par exemple en utilisant un substrat de verre à la place d'un substrat de silicium.

Cette activation thermique permet au matériau getter de réaliser, par l'intermédiaire notamment de la première face 107 et de la seconde face 109 de la couche 108 ainsi que du support formé par la paroi périphérique 110 et les espaceurs 112, une absorption des molécules gazeuses présentes dans la cavité 1004, et donc de réaliser par exemple dans cette cavité 1004 un vide poussé. Cette activation thermique du matériau getter peut être réalisée pendant ou après l'assemblage de la structure 100 aux parois latérales 1008. La température d'activation thermique dépend notamment de la nature chimique du matériau getter ou de la composition de l'alliage formant le matériau getter. Cette température peut être comprise entre environ 200°C et 500°C, et être maintenue par exemple pendant quelques minutes, ou une ou plusieurs heures pour réaliser l'activation thermique.

Il est également possible de réaliser une activation thermique par effet joule en faisant passer un courant directement dans le matériau getter lorsque la conductivité thermique de celui-ci est suffisante.

Par rapport à une simple couche de matériau getter déposée sur une paroi de la cavité 1004, cette structure 100 à couche 108 de matériau getter suspendue permet d'offrir une grande surface d'absorption grâce aux parois de matériau getter de la cavité 116 qui sont également en contact avec l'environnement gazeux de la cavité 1004, et notamment la première face 107 de la couche 108 et la seconde face 109 qui est laissée découverte. De plus, aucun élément reporté sur la couche 108 de matériau getter ne vient ajouter de l'inertie thermique à la structure 100 comportant le getter suspendu.

Dans une variante du premier mode de réalisation décrit ci-dessus, il est possible que du matériau getter ne soit pas déposé autour de la couche sacrificielle 104, ne formant pas de paroi périphérique soutenant la couche de matériau getter 108. Ainsi, la couche de matériau getter 108 est soutenue uniquement par les espaceurs 112 formés par le matériau getter déposé dans les ouvertures 106 à travers la couche sacrificielle 104.

Il est également possible qu'une couche de protection du matériau getter soit déposée sur la couche 108 et éventuellement sur la paroi périphérique 110 durant le procédé de réalisation de la structure 100. Ainsi, on minimise les risques de contamination, d'oxydation et d'absorption gazeuse possibles du matériau getter avant le confinement du matériau getter dans la cavité 1004. Cette couche de protection peut par exemple être à base de chrome et/ou de cuivre. Cette couche de protection peut avoir une épaisseur comprise entre environ 5 nm et 500 nm. Cette couche de protection est supprimée avant que la structure getter ne soit utilisée pour fermée la cavité 1004, par exemple par gravure chimique sélective. Toutefois, si cette couche de protection sert également de barrière à l'effet getter, cette couche peut être alors à base de métal, d'oxyde ou encore de nitrure.

Il est également possible d'utiliser une sous-couche de protection déposée entre la couche sacrificielle et la couche de matériau getter pouvant ne pas faire barrière à l'effet getter. Ainsi, la face arrière de la couche getter et la sous-couche en regard avec la cavité peuvent avoir une fonction getter. Cette couche de protection peut être conservée ou éliminée, entièrement ou seulement en partie.

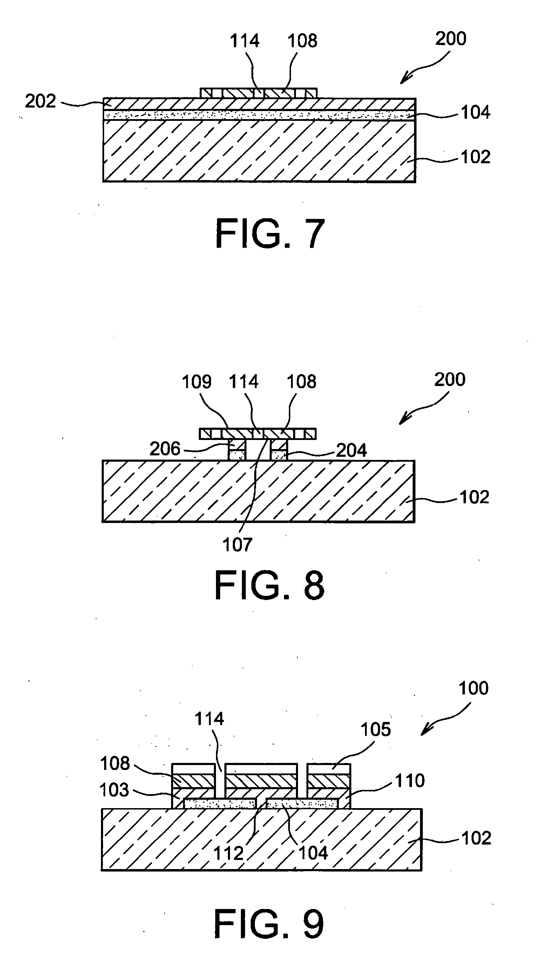

La figure 9 représente la structure getter 100 selon une variante de réalisation. Par rapport à la structure getter représentée sur la figure 3, la structure getter 100 selon cette variante de réalisation comporte une sous-couche de protection 103, par exemple à base de chrome et/ou de cuivre, déposée sur la couche sacrificielle 104 préalablement au dépôt de la couche 108 de matériau getter. De plus, la couche de matériau getter 108 est ici une bicouche comprenant la couche de matériau getter proprement dite et une couche de protection 105 déposée sur le matériau getter, cette couche de protection 105 pouvant également être à base de chrome et/ou de cuivre. Les ouvertures 114 ont été réalisées à travers la couche 108 de matériau getter, ainsi qu'à travers la couche de protection 105 et la sous-couche de protection 103. Enfin, dans cette variante de réalisation, les portions de la couche sacrificielle 104 ont été conservées. Il convient de noter qu'une telle couche de protection, contrairement à un élément massif qui serait disposé contre la couche de matériau getter, n'empêche pas le matériau getter de réaliser une absorption gazeuse. De plus, une telle couche de protection ne forme pas un pont thermique de conduction avec le matériau getter.

On se réfère maintenant aux figures 5 à 8 qui représentent les étapes d'un procédé de réalisation d'une structure getter 200 selon un second mode de réalisation.

Comme représenté sur la figure 5, la structure getter 200 comporte le substrat 102, par exemple similaire à celui décrit en liaison avec le premier mode de réalisation, sur lequel est formée la couche sacrificielle 104, également similaire à celle décrite précédemment.

Une couche d'adhérence 202 est ensuite déposée sur la couche sacrificielle 104 (voir figure 6). Cette couche d'adhérence 202 peut être à base de titane et/ou de zirconium et/ou de chrome. En fonction du matériau choisi pour réaliser cette couche d'adhérence 202, elle peut avoir des propriétés absorbantes vis-à-vis d'espèces gazeuses. L'épaisseur de cette couche d'adhérence 202 peut être comprise entre environ 5 nm et 100 nm.

Comme représenté sur la figure 7, on dépose ensuite sur la couche d'adhérence 202 un matériau getter, formant une couche 108 par exemple similaire à celle décrite précédemment en liaison avec le premier mode de réalisation. Cette couche 108 est ensuite structurée, formant ainsi des ouvertures 114 à travers cette couche 108. La couche d'adhérence 202 permet d'améliorer l'accroche du matériau getter à la couche sacrificielle 104.

On réalise ensuite une gravure de la couche sacrificielle 104 et de la couche d'adhérence 202, notamment à travers les ouvertures 114 formées dans la couche 108 de matériau getter. Les portions restantes de la couche sacrificielle 104 forment ainsi des espaceurs 204, sur lesquels sont disposées les portions restantes de la couche d'adhérence 202, formant des espaceurs 206.

Comme dans le premier mode de réalisation décrit précédemment, on obtient donc une couche 108 de matériau getter qui n'est pas en contact thermique direct avec le substrat 102, mais est reliée à celui-ci par l'intermédiaire d'un support formé ici par les espaceurs 204 à base du matériau de la couche sacrificielle 104 et les espaceurs 206 à base du matériau de la couche d'adhérence 202. La géométrie et la répartition des espaceurs 204, 206 peuvent être similaires à celles des espaceurs 112 décrits précédemment.

Comme précédemment, la structure getter 200 est ensuite intégrée sur un substrat comportant une cavité dans laquelle est disposé un dispositif microélectronique, formant une paroi de la cavité. Le matériau getter de la structure 200, c'est-à-dire ici la couche 108, est également activé thermiquement.

De plus, cette structure de matériau getter suspendue permet d'offrir une plus grande surface d'absorption par rapport aux structures getter de l'art antérieur car seules les surfaces de la couche 108 en contact avec les espaceurs 206 ne font pas parties de la surface totale d'absorption de la couche 108 de matériau getter. L'absorption gazeuse est donc réalisée par la seconde face 109 de la couche 108 qui est laissée découverte, et par les parties de la première face 107 de la couche 108 qui ne sont pas en contact avec les espaceurs 206.

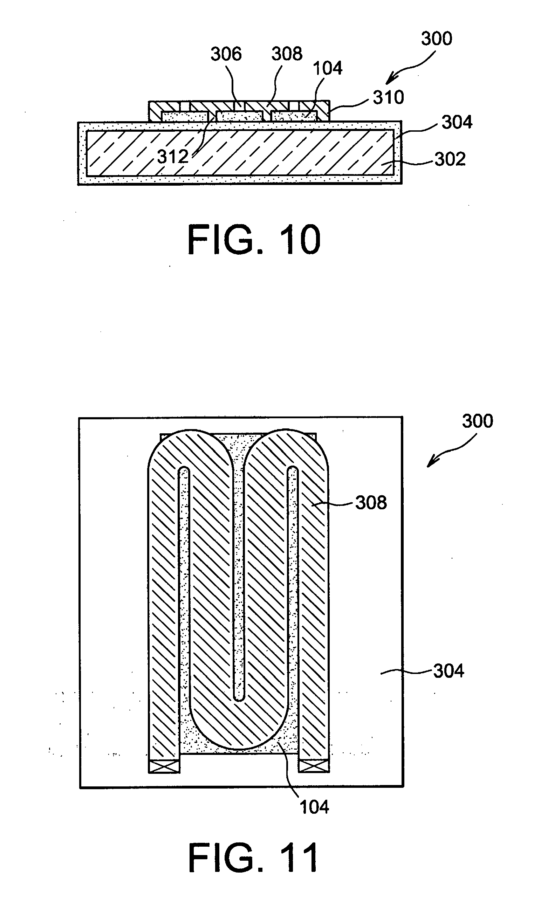

On se réfère aux figures 10 à 13 qui représentent les étapes d'un procédé de réalisation d'une structure getter 300 selon un troisième mode de réalisation.

La structure getter 300 comporte un substrat 302 à base de silicium, sur lequel est formée une couche d'oxyde de silicium 304 réalisant une couche d'isolation thermique autour du substrat 302 (figure 10). Comme dans le premier mode de réalisation, une couche sacrificielle 104 est formée sur la couche d'oxyde 304 et structurée, formant ainsi des ouvertures à travers cette couche 104. Un matériau destiné à servir de matériau chauffant, par exemple du tungstène ou tout autre matériau approprié, est déposé sur la couche sacrificielle 104, formant ainsi une couche 308. Comme représenté sur la figure 11, ce dépôt de matériau chauffant est structuré selon un motif de « serpentin », c'est-à-dire formant une ligne continue coudée plusieurs fois en forme d'épingles successives. Dans une variante, ce motif pourrait également former une ligne continue enroulée en spirale. Une telle structuration permet à la couche 308 de réaliser une bonne résistance chauffante. Les portions du matériau chauffant déposées à côté de la couche sacrificielle 104 forment une paroi périphérique 310, et le matériau chauffant déposé dans les ouvertures formées à travers la couche sacrificielle 104 forme des espaceurs 312 soutenant la couche 308 formée par le matériau chauffant déposé au-dessus de la couche sacrificielle 104. Il est également possible que la paroi périphérique 310 ne soit pas présente, la couche 308 étant alors soutenue uniquement par les espaceurs 312.

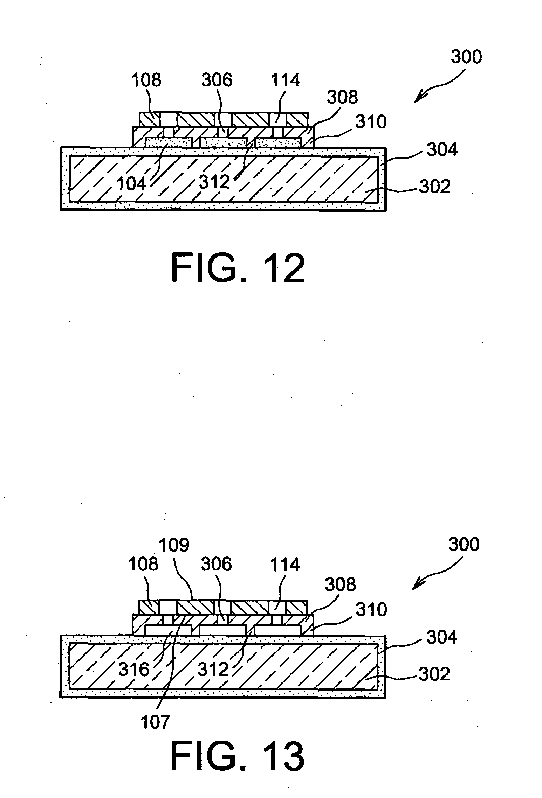

Comme représenté sur la figure 12, une couche 108 de matériau getter est déposée sur la couche 308 de matériau chauffant. Eventuellement, une couche électriquement isolante peut être déposée sur la couche 308 de matériau chauffant préalablement au dépôt de la couche 108 de matériau getter lorsque le matériau getter présente une résistivité électrique inférieure à celle du matériau chauffant. Une telle couche électriquement isolante est par exemple à base d'oxyde et/ou de nitrure de silicium et a par exemple une épaisseur comprise entre environ 100 nm et 1 µm. La couche 108 est également structurée de manière à former des ouvertures 114 à travers la couche 108 de matériau getter, formant un accès à la couche sacrificielle 104 par l'intermédiaire des ouvertures 306 formées à travers la couche de matériau chauffant 308.

La couche 108 de matériau getter est donc ici isolée du substrat 302 et supportée par le support formé par la couche 308, la paroi périphérique 310 et les espaceurs 312 de matériau chauffant. La densité des espaceurs 312 et/ou les dimensions de ces piliers 312 sont adaptées aux contraintes mécaniques supplémentaires apportées par la présence de la couche 308 de matériau chauffant en plus de la couche 108 de matériau getter.

La couche sacrificielle 104 est ensuite supprimée, par exemple par une gravure à travers les ouvertures 306 et les ouvertures 114, libérant ainsi la structure formée par le matériau chauffant et le matériau getter. On obtient ainsi une cavité 316 formée sous la couche 308 et dans laquelle sont disposés les espaceurs 312. La paroi périphérique 310 délimite ici la cavité 316.

Comme dans les modes de réalisation précédents, la structure getter 300 est ensuite intégrée sur un substrat comportant une cavité dans laquelle est disposé un dispositif microélectronique, formant ainsi une paroi de la cavité (figure 13). Le matériau getter de la structure 300, c'est-à-dire ici la couche 308, est également activé thermiquement en faisant passer un courant à travers la couche 308 de matériau chauffant. Un ou plusieurs contacts peuvent notamment être réalisés à travers un via formé dans le substrat 302 pour contacter le matériau chauffant afin de pouvoir amener le courant dans la couche 308 de matériau chauffant. L'absorption gazeuse est donc notamment réalisée par la seconde face 109 de la couche 108 de matériau getter.

## Revendications

1. Structure getter (100, 200, 300) comportant un substrat (102, 302) et au moins une couche (108) à base d'au moins un matériau getter reliée mécaniquement au substrat (102, 302) par l'intermédiaire d'au moins un support (110, 112, 204, 308, 310, 312), une première face (107) de la couche de matériau getter (108) étant en contact avec le support (110, 112, 204, 308, 310, 312), et une seconde face (109) de la couche (108) de matériau getter, opposée à ladite première face (107), étant au moins en partie découverte, caractérisée ce que :
- la surface du support (110, 112, 204, 308, 310, 312) en contact avec le substrat (102, 302) est inférieure à la surface de la première face (107) de la couche (108) de matériau getter ;
- le support comporte une paroi périphérique (110, 310) d'une cavité (116, 316) disposée entre la couche (108) de matériau getter et le substrat (102, 302), au moins une ouverture (114) étant réalisée à travers la couche (108) de matériau getter et formant un accès à la cavité (116, 316).

2. Structure (100, 200) selon la revendication 1, dans lequelle la surface de la première face (107) de la couche (108) de matériau getter en contact avec le support (110, 112, 204) est inférieure à la surface de la première face (107) de la couche (108) de matériau getter qui n'est pas en contact avec le support (110, 112, 204).

3. Structure (100, 200, 300) selon l'une des revendications précédentes, dans laquelle la couche (108) de matériau getter a pour unique pont thermique de conduction le support (110, 112, 204, 308, 310, 312).

4. Structure (100, 200) selon l'une des revendications précédentes, le substrat (102) étant à base de verre.

5. Structure (100, 200, 300) selon l'une
des revendications précédentes, la couche (108) à base du matériau getter ayant une épaisseur comprise entre environ 0,2 µm et 2 µm.

6. Structure (100, 200, 300) selon l'une des revendications précédentes, le matériau getter étant à base de titane et/ou de zirconium et/ou d'hafnium.

7. Structure (100) selon l'une des revendications précédentes, le support (110, 112) étant au moins en partie à base d'un matériau getter.

8. Structure (100, 200, 300) selon l'une des revendications précédentes, le support comportant au moins un espaceur (112, 204, 312) disposé entre la couche (108) de matériau getter et le substrat (102, 302).

9. Structure (300) selon l'une des revendications 1 à 7, le support comportant au moins
une couche structurée (308) à base d'au moins un matériau résistif et au moins un espaceur (312) disposé entre la couche résistive (308) et le substrat (302), la couche (108) de matériau getter étant disposée contre la couche résistive (308).

10. Structure (300) selon la revendication 9, l'espaceur (312) étant à base du matériau résistif.

11. Structure (300) selon l'une des revendications 9 ou 10, le motif de structuration de la couche resistive (308) étant un serpentin.

12. Structure (300) selon l'une des revendications 9 à 11, la couche (108) de matériau getter étant structurée selon un motif sensiblement similaire à celui de la couche résistive (308).

13. Structure (100, 200, 300) selon l'une des revendications 8 à 12, l'espaceur (112, 204, 312) comportant, dans un plan parallèle au plan de la face principale de la couche (108) de matériau getter, une section dont la surface est comprise entre environ 4 µm² et 25 µm².

14. Structure (100, 200, 300) selon l'une des revendications 8 à 13, dans laquelle, lorsque le support comporte une pluralité d'espaceurs (112, 204, 312), deux espaceurs voisins étant séparés l'un de l'autre d'une distance comprise entre environ 20 µm et 50 µm.

15. Structure (200, 300) selon l'une des revendications précédentes, comportant en outre une couche d'isolation thermique (304) et/ou une couche d'adhérence (202, 206) disposées entre le support (204) et la couche (108) de matériau getter et/ou entre le support (308, 310, 312) et le substrat (302).

16. Structure (200, 300) selon la
revendication 15, la couche d'isolation thermique (304) étant à base d'un oxyde de semi-conducteur et/ou la
couche d'adhérence (202, 206) étant à base de titane et/ou de chrome et/ou de zirconium.

17. Structure (100, 200) selon l'une des revendications précédentes, le substrat (102) étant à base d'au moins un matériau transparent à au moins une longueur d'onde pouvant être absorbée par le matériau getter.

18. Système microélectronique (1000) comportant au moins une cavité (1004) délimitée par des parois (100, 1008, 1002) et dans laquelle est disposé au moins un dispositif microélectronique (1006), au moins une paroi de la cavité (1004) du système microélectronique (1000) étant formée par une structure getter (100) selon l'une des revendications 1 à 17, la couche (108) de matériau getter de la structure getter (100) étant disposée dans la cavité (1004) du système microélectronique (1000).

19. Système (1000) selon la revendication 18, dans lequel le dispositif microélectronique (1006) est disposé au niveau d'une paroi de la cavité (1004) du système microélectronique (1000) autre que celle formée par la structure getter (100).

20. Système (1000) selon l'une des revendications 18 ou 19, le dispositif microélectronique (1006) comportant au moins un MEMS et/ou un NEMS.

21. Procédé de réalisation d'une structure getter (100, 200, 300), **caractérisé en ce qu'**il comporte au moins les étapes de :
- dépôt d'une couche sacrificielle (104) sur un substrat (102, 302)
- dépôt d'un matériau getter, formant au moins une couche (108) à base du matériau getter telle que la couche sacrificielle (104) soit disposée entre la couche (108) de matériau getter et le substrat (102, 302) ;
- suppression d'au moins une partie de la couche sacrificielle (104), formant un support (110, 112, 204, 308, 310, 312) reliant mécaniquement la couche (108) de matériau getter au substrat (102, 302), la surface du support (110, 112, 204, 308, 310, 312) en contact avec le substrat (102, 302) étant inférieure à la surface d'une face (107) de la couche (108) de matériau getter, ladite face (107) étant en contact avec le support (110, 112, 204, 308, 310, 312).

22. Procédé selon la revendication 21, dans lequel une seconde face (109) de la couche (108) de matériau getter, opposée à la face (107) de la couche (108) de matériau getter en contact avec le support (110, 112, 204, 308, 310, 312), est au moins en partie découverte.

23. Procédé selon l'une des revendications 21 ou 22, dans lequel la surface de la face (107) de la couche (108) de matériau getter en contact avec le support (110, 204) est inférieure à la surface de la face (107) de la couche (108) de matériau getter qui n'est pas en contact avec le support (110, 112, 204).

24. Procédé selon l'une des revendications 21 à 23, dans lequel la couche (108) de matériau getter a pour unique pont thermique de conduction le support (110, 112, 204, 308, 310, 312).

25. Procédé selon l'une des revendications 21 à 24, le dépôt du matériau getter étant également réalisé autour de la couche sacrificielle (104), le matériau getter déposé autour de la couche sacrificielle (104) forman't au moins une partie du support (110, 310).

26. Procédé selon l'une des revendications 21 à 25, comportant en outre, entre l'étape de dépôt de la couche sacrificielle (104) et l'étape de dépôt du matériau getter, une étape de réalisation d'au moins une ouverture (106) à travers la couche sacrificielle (104), le dépôt du matériau getter étant également réalisé dans l'ouverture (106), le matériau getter déposé dans l'ouverture (106) formant au moins une partie du support (112, 312).

27. Procédé selon l'une des revendications 21 à 26, comportant en outre, entre l'étape de dépôt du matériau getter et l'étape de suppression de la partie de la couche sacrificielle (104), une étape de réalisation d'au moins une ouverture (114) à travers le matériau getter, formant un accès à la couche sacrificielle (114), la suppression de la partie de la couche sacrificielle (114) étant réalisée au moins par l'intermédiaire de cette ouverture (114).

28. Procédé selon l'une des revendications 26 ou 27, la réalisation de l'ouverture (106) à travers la couche sacrificielle (104) et/ou la réalisation de l'ouverture (114) à travers le matériau getter étant obtenue par au moins une étape de lithographie et une étape de gravure.

29. Procédé selon l'une des revendications 21 à 28, la ou les parties restantes (204) de la couche sacrificielle (104) formant, après l'étape de suppression d'une partie de la couche sacrificielle (104), au moins une partie du support.

30. Procédé selon l'une des revendications 21 à 29, comportant en outre, entre l'étape de dépôt de la couche sacrificielle (104) et l'étape dépôt du matériau getter, une étape de structuration de la couche sacrificielle (104).

31. Procédé selon l'une des revendications 21 à 30, comportant en outre, entre l'étape de dépôt du matériau getter et l'étape de suppression d'une partie de la couche sacrificielle (104), une étape de structuration de la couche (108) de matériau getter.

32. Procédé selon l'une des revendications 21 à 31, comportant en outre au moins une étape de dépôt d'une couche (308) à base d'au moins un matériau résistif sur la couche sacrificielle (104) ou sur la couche (108) de matériau getter, mise en oeuvre entre l'étape de dépôt de la co;uche sacrificielle (104) et l'étape de dépôt du matériau getter ou entre l'étape de dépôt du matériau getter et l'étape de suppression d'une partie de la couche sacrificielle (104), la couche (108) de matériau guetter étant disposée sur ou sous la couche résistive (308).

33. Procédé selon la revendication 32, comportant en outre, après l'étape de dépôt de la couche résistive (308), une étape de structuration de la couche résistive (308) et/ou une étape de réalisation d'ouvertures (306) à travers la couche résistive (308).

34. Procédé selon l'une des revendications 21 à 33, comportant en outre une étape de dépôt d'une couche d'isolation thermique (304) et/ou d'une couche d'adhérence (202) sur le support (204), mise en oeuvre entre l'étape de dépôt de la couche sacrificielle (104) et l'étape de dépôt du matériau getter, et/ou sur le substrat (302), mise en oeuvre avant l'étape de dépôt de la couche sacrificielle (104).

35. Procédé selon l'une des revendications 21 à 34, le dépôt du matériau getter étant réalisé par évaporation et/ou pulvérisation.

36. Procédé selon l'une des revendications 21 à 35, la suppression de la partie de la couche sacrificielle (104) étant réalisée par une étape de gravure plasma ou de gravure humide.

37. Procédé selon l'une des revendications 21 à 36, comportant en outre, après l'étape de dépôt du matériau getter, une étape de dépôt d'une couche protectrice sur le matériau getter, et une étape de suppression de la couche protectrice mise en oeuvre après l'étape de suppression d'une partie de la couche sacrificielle (104).

38. Procédé de réalisation d'un système microélectronique (1000), comportant au moins les étapes de :
- mise en oeuvre d'un procédé de réalisation d'une structure getter (100) selon l'une des revendications 21 à 37,
- fermeture d'une cavité (1004) délimitée par des parois (100, 1002, 1008) dans laquelle est disposé au moins un dispositif microélectronique (1006), la structure getter (100) formant une paroi de la cavité (1004), la couche (108) de matériau getter de la structure getter (100) étant disposée dans la cavité (1004).

39. Procédé selon la revendication 38 dans lequel le dispositif microélectronique (1006) est disposé au niveau d'une paroi de la cavité (1004) autre que celle formée par la structure getter (100).

## Patentansprüche

1. Getter-Struktur (100, 200, 300) mit einem Substrat (102, 302) und wenigstens einer Schicht (108) auf der Basis von wenigstens einem Getter-Material, mechanisch verbunden mit dem Substrat (102, 302) durch wenigstens einen Träger (110, 112, 204, 308, 310, 312), wobei eine erste Seite (107) der Gettermaterialschicht (108) in Kontakt ist mit dem Träger (110, 112, 204, 308, 310, 312), und eine der genannten ersten Seite (107) entgegengesetzte zweite Seite (109) der Gettermaterialschicht (108) wenigstens teilweise unbedeckt ist,
**dadurch gekennzeichnet dass** :
- die Oberfläche des Trägers (110, 112, 204, 308, 310, 312), die in Kontakt mit dem Substrat (102, 302) ist, kleiner ist als die Oberfläche der ersten Seite (107) der Gettermaterialschicht (108) ;
- der Träger eine periphere Wand (110, 310) eines zwischen der Gettermaterialschicht (108) und dem Substrat (102, 302) befindlichen Hohlraums (116, 316) umfasst, wobei wenigstens eine die Gettermaterialschicht (108) durchquerende Öffnung (114) einen Zugang zu dem Hohlraum (116, 316) bildet.

2. Struktur (100, 200) nach Anspruch 1, bei der die Oberfläche der ersten Seite (107) der Gettermaterialschicht (108), die in Kontakt mit dem Träger (110, 112, 204) ist, kleiner ist als die Oberfläche der ersten Seite (107) der Gettermaterialschicht (108), die nicht in Kontakt mit dem Träger (110, 112, 204) ist.

3. Struktur (100, 200, 300) nach einem der vorhergehenden Ansprüche, bei der der Träger (110, 112, 204, 308, 310, 312) die einzige Wärmebrücke für die Schicht (108) aus Gettermaterial ist.

4. Struktur (100, 200) nach einem der vorhergehenden Ansprüche, wobei Glas als Basis für das Substrat (102) dient.

5. Struktur (100, 200, 300) nach einem der vorhergehenden Ansprüche, wobei die Schicht (108) auf der Basis des Gettermaterials eine zwischen ungefähr 0,2 µm und 2 µm enthaltene Dicke hat.

6. Struktur (100, 200, 300) nach einem der vorhergehenden Ansprüche, wobei Titan und/oder Zirconium als Basis für das Gettermaterial dienen.

7. Struktur (100) nach einem der vorhergehenden Ansprüche, wobei ein Gettermaterial wenigstens teilweise als Basis für den Träger (110, 112) dient.

8. Struktur (100, 200, 300) nach einem der vorhergehenden Ansprüche, wobei der Träger wenigstens einen Abstandshalter (112, 204, 312) umfasst, angeordnet zwischen der Gettermaterialschicht (108) und dem Substrat (102, 302).

9. Struktur (300) nach einem der Ansprüche 1 bis 7, wobei der Träger eine strukturierte Schicht (308) auf der Basis von wenigstens einem resistiven Material und wenigstens einen Abstandshalter (312) umfasst, angeordnet zwischen der resistiven Schicht (308) und dem Substrat (302), wobei die Gettermaterialschicht (108) auf der resistiven Schicht (308) angeordnet ist.

10. Struktur (300) nach Anspruch 9 mit einem Abstandshalter (312) auf Basis des resistiven Materials.

11. Struktur (300) nach einem der Ansprüche 9 oder 10, wobei das Muster der Strukturierung der resistiven Schicht (308) schlangenlinienartig ist.

12. Struktur (300) nach einem der Ansprüche 9 bis 11, wobei die Gettermaterialschicht (108) entsprechend einem Muster strukturiert ist, das im Wesentlichen dem der resistiven Schicht (308) ähnlich ist.

13. Struktur (100, 200, 300) nach einem der Ansprüche 8 bis 12, wobei der Abstandshalter (112, 204, 312) in einer Ebene, parallel zu der Ebene der Hauptseite der Gettermaterialschicht (108), einen Teilbereich umfasst, dessen Oberfläche zwischen ungefähr 4 µm² und 25 µm² enthalten ist.

14. Struktur (100, 200, 300) nach einem der Ansprüche 8 bis 13, bei der, wenn der Träger eine Vielzahl Abstandshalter (112, 204, 312) umfasst, zwei benachbarte Abstandshalter voneinander getrennt sind durch einen zwischen ungefähr 20 µm und 50 µm enthaltenen Abstand.

15. Struktur (200, 300) nach einem der vorhergehenden Ansprüche, außerdem umfassend eine thermische Isolationsschicht (304) und/oder eine Haftschicht (202, 206), angeordnet zwischen dem Träger (204) und der Gettermaterialschicht (108) und/oder zwischen dem Träger (308, 310, 312) und dem Substrat (302).

16. Struktur (200, 300) nach Anspruch 15, wobei ein Halbleiteroxid der thermischen Isolationsschicht (304) als Basis dient, und/oder Titan und/oder Chrom und/oder Zirconium der Haftschicht (202, 206) als Basis dient.

17. Struktur (100, 200) nach einem der vorhergehenden Ansprüche, wobei das Basismaterial des Substrats (102) durchlässig ist für wenigstens eine Wellenlänge, die durch das Gettermaterial absorbiert werden kann.

18. Mikroelektronisches System (1000), umfassend wenigstens einen durch Wände (100, 1008, 1002) begrenzten Hohlraum (1004), in dem wenigstens eine mikroelektronische Vorrichtung (1006) angeordnet ist, wobei wenigstens eine Wand des Hohlraums (1004) des mikroelektronischen Systems (1000) durch eine Getter-Struktur (100) nach einem der Ansprüche 1 bis 17 gebildet wird und die Gettermaterialschicht (108) der Getter-Struktur (100) sich in dem Hohlraum (1004) des mikroelektronischen Systems (1000) befindet.

19. System (1000) nach Anspruch 18, bei dem die mikroelektronische Vorrichtung (1006) in Höhe einer anderen als der durch die Getter-Struktur (100) gebildeten Wand des Hohlraums (1004) des mikroelektronischen Systems (1000) angeordnet ist.

20. System (1000) nach einem der Ansprüche 18 oder 19, wobei die mikroelektronische Vorrichtung (1006) wenigstens ein MEMS und/oder ein NEMS umfasst.

21. Verfahren zur Realisierung einer Getter-Struktur (100, 200, 300),
**dadurch gekennzeichnet, dass** es wenigstens die folgenden Schritte umfasst :
- Abscheiden einer Opferschicht (104) auf einem Substrat (102, 302) ;
- Abscheiden eines Gettermaterials zur Bildung von wenigstens einer Schicht (108) auf Basis des Gettermaterials, so dass die Opferschicht (104) sich zwischen der Gettermaterialschicht (108) und dem Substrat (102, 302) befindet ;
- Beseitigen wenigstens eines Teils der einen Träger (110, 112, 204, 308, 310, 312) bildenden Opferschicht (104), welche die Gettermaterialschicht (108) mit dem Substrat (102, 302) mechanisch verbindet, wobei die Oberfläche des Trägers (110, 112, 204, 308, 310, 312), die in Kontakt mit dem Substrat (102, 302) ist, kleiner ist als die Oberfläche einer Seite (107) der Gettermaterialschicht (108), wobei die genannte Seite (107) in Kontakt ist mit dem Träger (110, 112, 204, 308, 310, 312).

22. Verfahren nach Anspruch 21, bei dem eine zweite Seite (109) der Gettermaterialschicht (108), die der Seite (107) der Gettermaterialschicht, die in Kontakt ist mit dem Träger (110, 112, 204, 308, 310, 312), entgegengesetzt ist, wenigstens teilweise unbedeckt ist.

23. Verfahren nach einem der Ansprüche 21 oder 22, bei dem die Oberfläche der Seite (107) der Gettermaterialschicht (108), die in Kontakt ist mit dem Träger (110, 112, 204), kleiner ist als die Oberfläche der Seite (107) der Gettermaterialschicht (108), die nicht in Kontakt ist mit dem Träger (110, 112, 204) .

24. Verfahren nach einem der Ansprüche 21 bis 23, bei dem der Träger (110, 112, 204, 308, 310, 312) die einzige Wärmebrücke für die Gettermaterialschicht (108) ist.

25. Verfahren nach einem der Ansprüche 21 bis 24, bei dem das Gettermaterial auch um die Opferschicht (104) herum abgeschieden wird, wobei das um die Opferschicht (104) herum abgeschiedene Gettermaterial wenigstens einen Teil des Trägers (110, 310) bildet.

26. Verfahren nach einem der Ansprüche 21 bis 25, außerdem umfassend, zwischen dem Schritt zur Abscheidung der Opferschicht (104) und dem Schritt zur Abscheidung des Gettermaterials, einen Schritt zur Realisierung wenigstens einer Öffnung (106) durch die Opferschicht (104) hindurch, wobei auch in der Öffnung (106) Gettermaterial abgeschieden wird und das in der Öffnung (106) abgeschiedene Gettermaterial wenigstens einen Teil des Trägers (112, 312) bildet.

27. Verfahren nach einem der Ansprüche 21 bis 26, außerdem umfassend, zwischen dem Schritt zur Abscheidung des Gettermaterials und dem Schritt zur Beseitigung des bzw. eines Teils der Opferschicht (104), einen Schritt zur Realisierung wenigstens einer Öffnung (114) durch das Gettermaterial hindurch, die einen Zugang zu der Opferschicht (114) bildet, wobei die Beseitigung des Teils der Opferschicht (114) wenigstens durch diese Öffnung (114) erfolgt.

28. Verfahren nach einem der Ansprüche 26 oder 27, wobei die Realisierung der Öffnung (106) durch die Opferschicht (104) hindurch und/oder die Realisierung der Öffnung (114) durch das Gettermaterial hindurch in wenigstens einem Lithographieschritt oder einem Ätzschritt realisiert wird.

29. Verfahren nach einem der Ansprüche 21 bis 28, bei dem die nach dem Schritt zur Beseitigung eines Teils der Opferschicht (104) verbliebenen Teile (204) der Opferschicht (104) wenigstens einen Teil des Trägers bilden.

30. Verfahren nach einem der Ansprüche 21 bis 29, außerdem, zwischen dem Schritt zur Abscheidung der Opferschicht (104) und dem Schritt zur Abscheidung des Gettermaterials, einen Schritt zur Strukturierung der Opferschicht (104) umfassend.

31. Verfahren nach einem der Ansprüche 21 bis 30, außerdem, zwischen dem Schritt zur Abscheidung des Gettermaterials und dem Schritt zur Beseitigung eines Teil der Opferschicht (104), einen Schritt zur Strukturierung der Gettermaterialschicht (108) umfassend.

32. Verfahren nach einem der Ansprüche 21 bis 31, außerdem wenigstens einen Schritt zu Abscheidung einer Schicht (308) auf der Basis von wenigstens einem resistiven Material auf der Opferschicht (104) oder auf der Gettermaterialschicht (108) umfassend, ausgeführt zwischen dem Schritt zu Abscheidung der Opferschicht (104) und dem Schritt zur Abscheidung des Gettermaterials oder dem Schritt zur Abscheidung des Gettermaterials und dem Schritt zur Beseitigung eines Teils der Opferschicht (104), wobei die Gettermaterialschicht (108) über oder unter der resistiven Schicht (308) angeordnet ist bzw. wird.

33. Verfahren nach Anspruch 32, außerdem, nach dem Schritt zur Abscheidung der resistiven Schicht (308), einen Schritt zur Strukturierung der resistiven Schicht und/oder einen Schritt zur Realisierung von Öffnungen (306) durch die resistive Schicht (308) hindurch umfassend.

34. Verfahren nach einem der Ansprüche 21 bis 33, außerdem umfassend einen Schritt zur Abscheidung einer thermischen Isolationsschicht (304) und/oder einer Haftschicht (202) auf dem Träger (204), ausgeführt zwischen dem Schritt zur Abscheidung der Opferschicht (104) und dem Schritt zur Abscheidung des Gettermaterials, und/oder auf dem Substrat (302), ausgeführt vor dem Schritt zur Abscheidung der Opferschicht (104).

35. Verfahren nach einem der Ansprüche 21 bis 34, bei dem die Abscheidung des Gettermaterials durch Verdampfung und/oder Zerstäubung erfolgt.

36. Verfahren nach einem der Ansprüche 21 bis 35, wobei die Beseitigung des Teil der Opferschicht (104) durch einen Plasmaätz- oder Naßätzschritt erfolgt.

37. Verfahren nach einem der Ansprüche 21 bis 36, außerdem umfassend, nach dem Schritt zur Abscheidung des Gettermaterials, einen Schritt zur Abscheidung einer Schutzschicht auf dem Gettermaterial, und einen Schritt zur Beseitigung der Schutzschicht, ausgeführt nach dem Schritt zur Beseitigung eines Teils der Opferschicht (104).

38. Verfahren zur Realisierung eines mikroelektronischen Systems (1000), wenigstens die folgenden Schritte umfassend :
- Durchführen eines Verfahrens zur Realisierung einer Getterstruktur (100) nach einem der Ansprüche 21 bis 37,
- Verschließen eines durch Wände (100, 1002, 1008) abgegrenzten Hohlraums (1004), in dem wenigstens eine mikroelektronische Vorrichtung (1006) angeordnet ist, wobei die Getterstruktur (100) eine Wand des Hohlraums (1004) bildet und die Gettermaterialschicht (108) der Getterstruktur (100) in dem Hohlraum (1004) angeordnet ist.

39. Verfahren nach Anspruch 38, bei dem die mikroelektronische Vorrichtung (1006) sich in Höhe einer anderen als der durch die Getterstruktur (100) gebildeten Wand des Hohlraums (1004) befindet.

## Claims

1. Getter structure (100, 200, 300) comprising a substrate (102, 302) and at least one getter material-based layer (108) mechanically connected to the substrate (102, 302) by means of at least one support (110, 112, 204, 308, 310, 312), a first face (107) of the getter material layer (108) being in contact with the support (110, 112, 204, 308, 310, 312), and a second face (109) of the getter material layer (108), opposite said first face (107), being at least partially exposed, **characterized in that**:
- the surface of the support (110, 112, 204, 308, 310, 312) in contact with the substrate (102, 302) is smaller than the surface of the first face (107) of the getter material layer (108),
- the support comprises a peripheral wall (110, 310) of a cavity (116, 316) arranged between the getter material layer (108) and the substrate (102, 302), at least one opening (114) being made through the getter material layer (108) and forming an access to the cavity (116, 316).

2. Structure (100, 200) according to claim 1, in which the surface of the first face (107) of the getter material layer (108) in contact with the support (110, 112, 204) is smaller than the surface of the first face (107) of the getter material layer (108) which is not in contact with the support (110, 112, 204).

3. Structure (100, 200, 300) according to one of the previous claims, wherein the getter material layer (108) has the support (110, 112, 204, 308, 310, 312) as the only conductive thermal bridge.

4. Structure (100, 200) according to one of the previous claims, in which the substrate (102) is glass-based.

5. Structure (100, 200, 300) according to one of the previous claims, in which the getter material-based layer (108) has a thickness between around 0.2 µm and 2 µm.

6. Structure (100, 200, 300) according to one of the previous claims, in which the getter material is titanium- and/or zirconium- and/or hafnium-based.

7. Structure (100) according to one of the previous claims, in which the support (110, 112) is at least partially based on a getter material.

8. Structure (100, 200, 300) according to one of the previous claims, in which the support comprises at least one spacer (112, 204, 312) arranged between the getter material layer (108) and the substrate (102, 302).

9. Structure (300) according to one of claims 1 to 7, in which the support comprises at least one structured layer (308) based on at least one resistive material and at least one spacer (312) arranged between the resistive layer (308) and the substrate (302), and the getter material layer (108) is arranged against the resistive layer (308).

10. Structure (300) according to claim 9, in which the spacers (312) is based on resistive material.

11. Structure (300) according to one of claims 9 or 10, in which the structuring pattern of the resistive layer (308) is a serpentine pattern.

12. Structure (300) according to one of claims 9 to 11, in which the getter material layer (108) is structured according to a pattern substantially similar to that of the resistive layer (308).

13. Structure (100, 200, 300) according to one of claims 8 to 12, in which the spacer (112, 204, 312) comprises, in a plane parallel to the plane of the main face of the getter material layer (108), a cross-section of which the surface is between around 4 µm² and 2 5 µm².

14. Structure (100, 200, 300) according to one of claims 8 to 13, in which, when the support comprises a plurality of spacers (112, 204, 312), two adjacent spacers are separated from one another by a distance between around 20 µm and 50 µm.

15. Structure (200, 300) according to one of the previous claims, also comprising a thermal insulation layer (304) and/or an adhesion layer (202, 206) arranged between the support (204) and the getter material layer (108) and/or between the support (308, 310, 312) and the substrate (302).

16. Structure (200, 300) according to claim 15, in which the thermal insulation layer (304) is based on a semiconductor oxide and/or the adhesion layer (202, 206) is based on titanium and/or chromium and/or zirconium.

17. Structure (100, 200) according to one of the previous claims, in which the substrate (102) is based on at least one material transparent to at least one wavelength capable of being absorbed by the getter material.

18. Microelectronic system (1000) comprising at least one cavity (1004) defined by walls (100, 1008, 1002) and in which at least one microelectronic device (1006) is arranged, in which at least one wall of the cavity (1004) is formed by a getter structure (100) according to one of claims 1 to 17, and the getter material layer (108) of the getter structure (100) is arranged in the cavity (1004) of the microelectronic system (1000).

19. System (1000) according to claim 18, in which the microelectronic device (1006) is arranged at a wall of the cavity (1004) other than the one formed by the getter structure (100).

20. System (1000) according to one of claims 18 or 19, in which the microelectronic device (1006) comprises at least one MEMS and/or one NEMS.

21. Process for producing a getter structure (100, 200, 300), **characterized in that** it comprises at least the steps of:
- depositing a sacrificial layer (104) on a substrate (102, 302);
- depositing a getter material, forming at least one getter material-based layer (108) so that the sacrificial layer (104) is arranged between the getter material layer (108) and the substrate (102, 302);
- at least partially removing the sacrificial layer (104), forming a support (110, 112, 204, 308, 310, 312) mechanically connecting the getter material layer (108) to the substrate (102, 302), in which the surface of the support (110, 112, 204, 308, 310, 312) in contact with the substrate (102, 302) is smaller than the surface of a face (107) of the getter material layer (108), in which said face (107) is in contact with the support (110, 112, 204, 308, 310, 312).

22. Process according to claim 21, in which a second face (109) of the getter material layer (108), opposite to the face (107) of the getter material layer (108) in contact with the support (110, 112, 204, 308, 310, 312), is at least partially exposed.

23. Process according to one of claims 21 or 22, in which the surface of the face (107) of the getter material layer (108) in contact with the support (110, 112, 204) is smaller than the surface of the face (107) of the getter material layer (108) which is not in contact with the support (110, 112, 204).

24. Process according to one of claims 21 to 23, wherein the getter material layer (108) has the support (110, 112, 204, 308, 310, 312) as the only conductive thermal bridge.

25. Process according to one of claims 21 to 24, in which the deposition of the getter material is also performed around the sacrificial layer (104), and the getter material deposited around the sacrificial layer (104) forms at least a portion of the support (110, 310).

26. Process according to one of claims 21 to 25, also comprising, between the step of depositing the sacrificial layer (104) and the step of depositing the getter material, a step of producing at least one opening (106) through the sacrificial layer (104), in which the deposition of the getter material is also performed in the opening (106), and the getter material deposited in the opening (106) forms at least a portion of the support (112, 312).

27. Process according to one of claims 21 to 26, also comprising, between the step of depositing the getter material and the step of removing the portion of the sacrificial layer (104), a step of producing at least one opening (114) through the getter material, forming an access to the sacrificial layer (114), in which the removal of the sacrificial layer portion (114) is performed at least by means of this opening (114).

28. Process according to one of claims 26 or 27, in which the production of the opening (106) through the sacrificial layer (104) and/or the production of the opening (114) through the getter material is achieved by at least one lithography step and one etching step.

29. Process according to one of claims 21 to 28, in which the remaining portion(s) (204) of the sacrificial layer (104) form(s), after the step of removing a portion of the sacrificial layer (104), at least one portion of the support.

30. Process according to one of claims 21 to 29, which also comprises, between the step of depositing the sacrificial layer (104) and the step of depositing the getter material, a step of structuring the sacrificial layer (104).

31. Process according to one of claims 21 to 30, which also comprises, between the step of depositing the getter material and the step of removing a portion of the sacrificial layer (104), a step of structuring the getter material layer (108).

32. Process according to one of claims 21 to 31, which also comprises at least one step of depositing a layer (308) based on at least one resistive material on the sacrificial layer (104) or on the getter material layer (108), implemented between the step of depositing the sacrificial layer (104) and the step of depositing the getter material or between the step of depositing the getter material and the step of removing a portion of the sacrificial layer (104), in which the getter material layer (108) is arranged on or under the resistive layer (308).

33. Process according to claim 32, which also comprise, after the step of depositing the resistive layer (308), a step of structuring the resistive layer (308) and/or a step of producing openings (306) through the resistive layer (308).

34. Process according to one of claims 21 to 33, which also comprises a step of depositing a thermal insulation layer (304) and/or an adhesion layer (202) on the support (204), implemented between the step of depositing the sacrificial layer (104) and the step of depositing the getter material, and/or on the substrate (302), implemented before the step of depositing the sacrificial layer (104).

35. Process according to one of claims 21 to 34, in which the deposition of the getter material is performed by evaporation and/or spraying.

36. Process according to one of claims 21 to 35, in which the removal of the portion of the sacrificial layer (104) is performed by a step of plasma etching or wet etching.

37. Process according to one of claims 21 to 36, which also comprises, after the step of depositing the getter material, a step of depositing a protective layer on the getter material, and a step of removing the protective layer implemented after the step of removing a portion of the sacrificial layer (104).

38. Process for producing a microelectronic system (1000), comprising at least the steps of:
- implementing a process for producing a getter structure (100) according to one of claims 21 to 37;
- closing a cavity (1004) defined by walls (100, 1002, 1008) in which at least one microelectronic device (1006) is arranged, and in which the getter structure (100) forms a wall of the cavity (1004), and the getter material layer (108) of the getter structure (100) is arranged in the cavity (1004).

39. Process according to claim 38, in which the microelectronic device (1006) is arranged at a wall of the cavity (1004) other than the one formed by the getter structure (100).
